Europäisches Patentamt

European Patent Office

Office européen des brevets

(19)

(11) **EP 1 235 318 A1**

(12) # DEMANDE DE BREVET EUROPEEN

(43) Date de publication:
**28.08.2002 Bulletin 2002/35**

(51) Int Cl.⁷: **H01S 5/14**, H01S 5/0625

(21) Numéro de dépôt: **02290422.1**

(22) Date de dépôt: **21.02.2002**

(84) Etats contractants désignés:
**AT BE CH CY DE DK ES FI FR GB GR IE IT LI LU MC NL PT SE TR**
Etats d'extension désignés:
**AL LT LV MK RO SI**

(30) Priorité: **23.02.2001 FR 0102490**

(71) Demandeur: **ALCATEL**
**75008 Paris (FR)**

(72) Inventeur: **Jacquet, Joel**
**91470 Limours (FR)**

(74) Mandataire: **Fournier, Michel**
**Companie Financière Alcatel, DPI,**
**30, Avenue Kléber**
**75116 Paris (FR)**

(54) **Laser accordable de façon rapide et large**

(57)    Le laser (1) accordable en longueur d'onde est constitué par une cavité résonante (2) en semiconducteur couplée à un réseaux réflecteur (31, 33) de Bragg échantillonné ayant des pics de réflectivité pour N fréquences optiques.

La cavité résonante (2) est formée de deux éléments réflecteurs opposés (13, 13') non sélectifs en longueur d'onde et délimitant une section amplificatrice (5) couplée à une section d'accord de phase (6). La longueur optique de la cavité est ajustable par effet électro optique en fonction d'une tension de commande qui lui est appliquée.

On obtient un laser accordable de façon rapide sur une large bande.

FIG. 3

EP 1 235 318 A1

## Description

### Domaine technique

L'invention se situe dans le domaine des lasers accordables. Il s'agit de lasers dont la longueur d'onde d'émission est réglable. L'emploi de tels lasers est particulièrement intéressant dans les systèmes de télécommunication optiques utilisant le multiplexage en longueur d'onde (dit "WDM", de l'anglais "Wavelength Division Multiplexing").

### Arrière plan technologique.

Des lasers dont la longueur d'onde peut être réglée sont déjà connus. Le document [1], dont la référence est donnée en fin de la présente description, décrit un laser accordable à réflecteur de Bragg distribué (dit "DBR", de l'anglais "Distributed Bragg Reflector). Le dispositif laser comporte une section amplificatrice mise bout à bout avec une section de Bragg sur laquelle une tension de réglage est appliquée, permettant d'accorder le laser. Deux mécanismes de réglage de la longueur d'onde ont été observés sur ce laser. L'un est basé sur l'injection standard de courant dans la section de Bragg, l'autre est basé sur l'application d'une tension polarisée en inverse permettant d'ajuster l'indice de réfraction par effet électro-optique. La gamme totale d'accord de ce laser incluant ces deux mécanismes est d'environ 120 angströms autour d'une longueur d'onde de 1,56 μm avec 31 modes régulièrement espacés de 3,5 angströms. 25 de ces modes sont obtenus par polarisation directe de la section de Bragg (injection de courant) avec une variation de tension de 1,6 volts, et 6 autres par une polarisation inverse de cette même section (effet électro-optique) avec une variation de tension de 4 volts. Avec un tel dispositif soumis à un effet électro-optique, il est expliqué qu'il a été possible d'obtenir des temps de commutation entre deux longueurs d'onde de 500 ps, et ceci indépendamment de l'écart entre les longueurs d'onde commutées. Ces temps de commutation augmentent jusqu'à plusieurs nanosecondes dans le cas de l'injection de courant.

Les lasers accordables par injection de courant sont les plus largement utilisés actuellement. Le délai minimum d'obtention de l'accord est cependant imposé par la durée de vie des porteurs dans la section d'accord. Selon le document [1], des délais courts de 500 picosecondes ont été obtenues par des effets électro-optiques. Cette rapidité relative, se fait aux dépens de la gamme d'accord qui est limitée selon [1] à 25 angströms.

Un laser accordable utilisant un autre principe est décrit dans le document [2], dont la référence est donnée en fin de la présente description. Ce document décrit un laser dans lequel un accord par pas est obtenu au moyen d'un laser à cavité externe délimitée par une fibre comportant un réseau de Bragg échantillonné. Le dispositif laser représenté en figure 1 de ce document comporte une diode laser formant une cavité de Fabry Pérot. Cette diode laser est couplée à une fibre optique comportant le réseau de Bragg échantillonné, lequel présente 8 pics principaux de réflexion. La face avant de la diode, faisant face à la fibre comporte une couche antireflet laissant subsister un coefficient de réflexion de $5.10^{-3}$. Le dispositif laser ainsi réalisé travaille en mode unique pour chacune des longueurs d'onde correspondant à un pic de réflexion du réseau de Bragg de la fibre. Le fonctionnement en mode unique est possible en raison de la faible réflectivité de la face avant conduisant à une cavité de Fabry-Pérot de finesse faible ayant un intervalle spectral libre (ISL) de 103 Ghz. La condition de gain est remplie lorsqu'un mode résiduel de la cavité de Fabry-Pérot a une longueur d'onde en coïncidence avec l'une des longueurs d'onde correspondant à un pic de réflexion de la fibre. Il est expliqué dans [2] que ce dispositif a permis de réaliser un dispositif laser dont la fréquence optique d'émission est réglable par pas de 100 Ghz, pour des longueurs d'onde allant de 1551,09 à 1556,66 nm, soit un espacement entre longueurs d'onde d'accord extrêmes de 6 nm environ. Le changement des longueurs d'onde est obtenu par variation du courant injecté dans le milieu de gain de la diode laser. La recherche d'une large gamme de longueurs d'onde d'accord conduit à de fortes injections de courant et en conséquence à une variation forte de puissance d'émission. Par ailleurs, le réglage obtenu par variation d'indice est principalement lié à un échauffement de la structure, l'effet et donc l'accordabilité seront très lents (ms).

### Brève description de l'invention

Par rapport à l'état de la technique qui vient d'être décrit l'invention propose un laser accordable qui puisse être accordé sur une large plage de longueurs d'onde, de l'ordre de 100 nm et plus, de façon simple, par action sur une seule grandeur de commande, et permettant d'obtenir de façon précise l'une quelconque des fréquences optiques de la grille ITU (International Telecommunication Union), avec un espacement entre fréquences consécutives petit, de 50 ou 100 GHz. De la sorte, un laser accordable selon l'invention peut être accordé sur un grand nombre de longueurs d'onde.

L'invention vise surtout à permettre des délais d'obtention d'accord très courts en vue d'une utilisation notamment en commutation optique.

Elle vise également la conception d'un laser accordable ayant une longévité améliorée et permettant une électronique de commande simplifiée. Elle vise en outre à produire une émission laser de bande étroite d'une grande pureté spectrale et exempte de bruit.

Plus précisément, l'invention est relative à un laser (1) accordable en longueur d'onde, comprenant une première cavité résonante contenant un milieu amplificateur optique, et un réflecteur extérieur à ladite première cavité délimitant une seconde cavité, ledit réflecteur présentant des pics de réflectivité pour un nombre entier N de fréquences optiques, caractérisé en ce que la première cavité est formée de deux éléments réflecteurs opposés non sélectifs en longueur d'onde et délimitant une première section active amplificatrice couplée à une seconde section active d'accord de phase, chacune des deux sections étant raccordable à une source électrique qui lui est propre, ladite seconde section active présentant un indice effectif de groupe réglable par effet électro-optique en fonction d'une tension électrique appliquée à ladite seconde section active, lesdites première et seconde sections actives étant dimensionnées de sorte que la différence entre les fréquences optiques de deux modes résonants quelconques de ladite première cavité ne soit jamais égale à la différence entre les fréquences optiques de deux pics de réflectivité quelconques dudit réflecteur.

Ainsi, un courant injecté dans la première section définit le gain de la première cavité. Par ailleurs, celle-ci étant délimitée par des éléments réflecteurs non sélectifs en longueur d'onde, la cavité est strictement de type "Fabry-Pérot". La différence entre les fréquences de deux modes résonants voisins quelconques est alors pratiquement une constante imposée essentiellement par les compositions et les dimensions des éléments constituant la première cavité. En faisant varier la tension appliquée à la seconde section, on provoque un glissement du peigne des fréquences de résonance de cette cavité. Le réglage de ces fréquences de résonance résulte d'un effet électro-optique : le champ électrique appliqué en inverse au travers de la structure (de type PIN) de la section d'accord de phase impose une valeur correspondante de l'indice de sa couche active et donc de l'indice effectif de groupe de la structure. Selon la structure choisie, l'effet électro-optique peut être l'effet de Franz-Keldish ou l'effet de Stark de confinement quantique. Ainsi, la longueur optique de la première cavité peut être modifiée en fonction de la tension appliquée, ce qui entraîne le glissement du peigne des fréquences de résonance.

Comme le réflecteur renvoie vers la première cavité une partie de la lumière que celle-ci émet, et comme la première cavité est conçue de sorte que la différence entre les fréquences optiques de deux modes résonants quelconques ne soit jamais égale à la différence entre les fréquences optiques de deux pics de réflectivité quelconques du réflecteur, un simple ajustement de la tension permet de faire coïncider sélectivement une seule des fréquences correspondant aux pics de réflectivité avec l'une des fréquences de résonance de la première cavité et c'est avec cette fréquence coïncidente unique que se produira l'oscillation laser du dispositif.

Un réflecteur extérieur présentant N pics de réflectivité peut être réalisé au moyen d'un guide d'ondes à réseau de Bragg échantillonné, comme décrit dans le document [2] déjà cité. Le réseau peut être constitué d'une suite d'échantillons de pas constant, régulièrement espacés le long du guide, auquel cas les coefficients de réflectivité des pics en fonction de la fréquence iront en décroissant selon une enveloppe en forme de Sinus Cardinal à partir d'une fréquence centrale correspondant à la fréquence de Bragg du réseau. Chaque échantillon peut aussi et de préférence être réalisé avec un profil d'indice le long du guide suivant une fonction en Sinus Cardinal et on obtiendra de la sorte des coefficients de réflectivité de même valeur, selon une enveloppe rectangulaire. Ce dernier mode de réalisation est avantageux dans la mesure où la condition de courant de seuil du laser est la même pour tous les pics de réflectivité. Le courant injecté dans la première section pouvant alors rester constant, les réglages sont facilités. Pour plus de détails sur la conception des réseaux de Bragg échantillonnés, on pourra consulter le document [4] dont la référence est donnée en fin de la présente description.

Dans le cas particulier important en pratique où la différence entre deux fréquences optiques voisines quelconques de pics de réflectivité est constante, on prévoira en outre avantageusement que les fréquences optiques des pics de réflectivité soient entrelacées avec des fréquences optiques consécutives de modes résonants. Cette disposition, toujours obtenue par un dimensionnement approprié des première et seconde sections actives, permet des plages de réglage où la valeur de fréquence (ou de longueur d'onde) sélectionnée est une fonction monotone de la tension appliquée. Ceci permet donc de simplifier la commande de tension.

De préférence dans ce dernier cas, le rapport de la différence entre deux fréquences optiques voisines de deux modes résonants à la différence entre deux fréquences optiques voisines de pics de réflectivité sera choisi égal à N/(N-1). Cette disposition assure que le passage d'une valeur de fréquence sélectionnée à la suivante s'effectue par un glissement du peigne des modes résonants selon un pas constant. Il en résulte une sélectivité identique sur toute la gamme de réglage.

Dans un mode préféré de réalisation, le réflecteur extérieur est un guide d'onde comportant au moins un réseau réflecteur de Bragg échantillonné optiquement couplé à la première cavité.

Le guide d'onde à réseau de Bragg échantillonné peut être une fibre ("Sampled Fiber Bragg Grating" ou SFBG) ou n'importe quel autre guide d'onde, en particulier un guide planaire en silice ou à base de polymère.

## Brève description des dessins

Des exemples de réalisation de la présente invention et des compléments seront ci-après donnés en liaison avec les dessins annexés dans lesquels :

- la figure 1 représente un mode général de réalisation de l'invention ;
- la figure 2 représente l'imbrication des valeurs de fréquence de résonance de la première cavité et des valeurs de fréquence des pics de réflectivité du réflecteur extérieur ;

- la figure 3 comporte les parties A, B, et C. Elle représente différents modes de réalisation et de couplage entre le guide d'onde à réseau de Bragg échantillonné et la première cavité;

- la figure 4 comporte les parties A, B, C, et D. Elle illustre un mode particulier de réalisation d'un réseau échantillonné permettant de réduire la longueur dudit réseau.

## Description de modes de réalisation

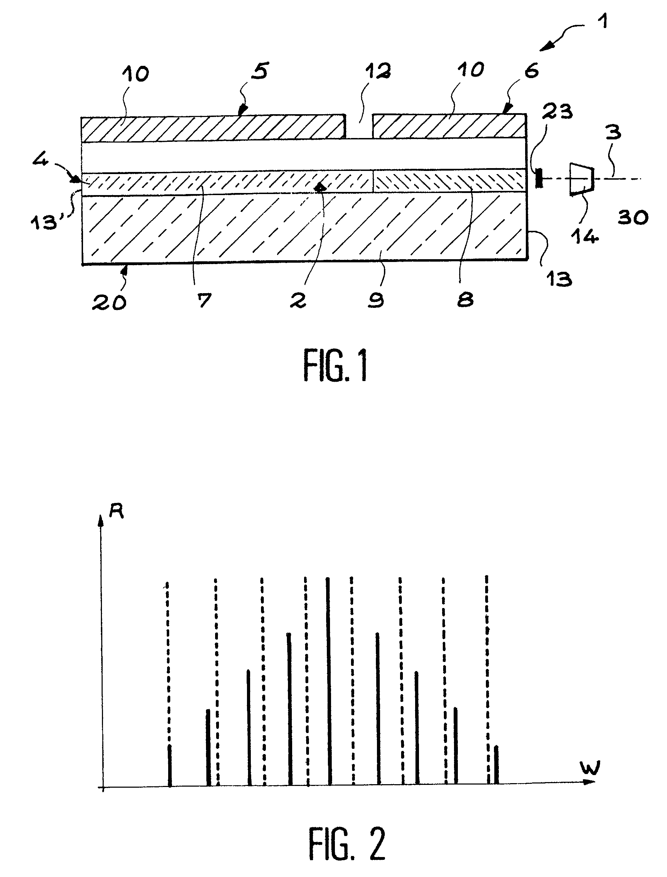

La figure 1 qui sera maintenant commentée, représente un mode général de réalisation du laser 1 selon l'invention.

Le laser 1 est essentiellement formé par un composant de type laser semi-conducteur 20 couplé à un réflecteur externe schématisé par un trait d'axe 3. Le composant 20 est contenu dans une première cavité résonante 2, tandis que le réflecteur 3 délimite une seconde cavité 11 couplée à la première.

Le composant 20 est formé sur un substrat commun 9, par exemple en InP, sur lequel a été formée une couche active 4 comprenant deux parties couplées 7, 8 situées dans le prolongement l'une de l'autre. Pour rendre guidantes ces deux parties 7, 8 de couche active, elles sont enterrées de façon en elle-même connue dans des couches de confinement non référencées sur les figures.

La première partie 7 de couche active est amplificatrice. Elle est par exemple constituée de puits quantiques multiples formés par une première séquence d'épitaxies. La seconde partie 8, formée par une étape ultérieure d'épitaxie, est constituée d'un milieu apte à présenter un effet électro-optique, par exemple l'effet de Franz-Keldysh.

Les deux parties 7, 8 de couche active permettent de définir deux sections respectivement de gain 5 et de phase 6. Pour cela, une couche de contact métallisée en surface 10 est située au dessus des couches de confinement. Les deux sections 5, 6 sont alors séparées électriquement par une gravure 12 effectuée dans la couche de contact 10 et dans une partie des couches de confinement situées au-dessus de la couche active 4. Outre une électrode inférieure non représentée, les sections 5, 6 possèdent donc des électrodes supérieures indépendantes aptes à recevoir respectivement un courant d'injection de porteurs et une tension de commande. Grâce à cette tension de commande, on peut donc changer la longueur optique de la première cavité 2 sans influence notable sur la puissance émise par le laser semi-conducteur 20.

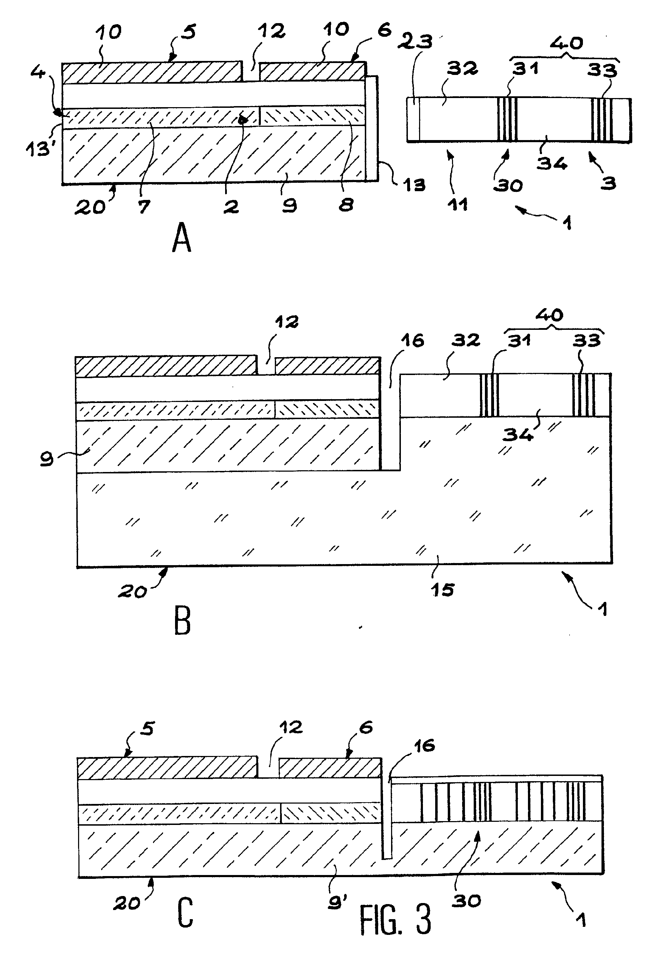

Comme montré de façon plus détaillée à la figure 3, le réflecteur 3 peut être sous la forme d'un guide d'onde 30, tel qu'une fibre optique, dans lequel est inscrit un réseau réflecteur de Bragg échantillonné 40 ("Sampled Bragg Grating"). Un tel réflecteur est constitué d'une alternance d'échantillons de réseaux réflecteurs de Bragg distribués (DBR ou "Distributed Bragg Reflector") 31, 33... et de sections de Fabry-Pérot 32, 34..., constituées chacune par une partie de guide d'onde uniforme sans réseau de Bragg. Il sera vu plus loin que dans un mode avantageux de réalisation, permettant de réduire la longueur totale de la partie de guide d'onde portant le réseau de Bragg échantillonné, plusieurs réseaux échantillonnés peuvent être imbriqués sur une même portion de guide. Dans ce cas les sections 32, 34... sont sans réseaux de Bragg à la même longueur d'onde. L'ensemble du réseau échantillonné est destiné à produire un peigne de pics de réflectivité, chaque pic correspondant à une longueur d'onde sur laquelle le laser 1 peut être accordé.

Selon un premier mode de réalisation, la première cavité 2 est formée entre une face arrière 13' réfléchissante du composant 20 et sa face avant 13 qui est traitée pour constituer un miroir semi-réfléchissant. La première cavité 2 est alors délimitée par la face extérieure 13' de la première section 5 et la face extérieure 13 de la seconde section 6.

Dans ce premier mode de réalisation, le coefficient de réflexion R2 de la face d'entrée 23 du guide d'onde 30, par exemple une extrémité de fibre en forme de lentille, doit être aussi faible que possible, de façon à éviter la formation d'une troisième cavité. La distance séparant la face avant 13 du composant 20 et la face d'entrée 23 de la fibre 30 peut être de l'ordre de plusieurs dizaines de microns. Il conviendra de tenir compte de cette distance dans le calcul de l'écart de phase de l'onde réfléchie par le réflecteur 3.

Selon un second mode de réalisation la cavité 2 pourra être avantageusement définie entre la face arrière 13' réfléchissante et la face d'entrée 23 du guide d'onde 30. Pour cela, la face d'entrée 23 constituera un miroir semi-réfléchissant. Dans ce cas, la face avant 13 de la couche active 4 devra être de réflectivité aussi faible que possible pour éviter les réflexions parasites et ainsi créer une cavité supplémentaire. Une telle réflectivité faible peut être obtenue par dépôt d'un diélectrique anti-réfléchissant ou par inclinaison du guide optique formé par la couche active 4 par rapport à la direction orthogonale du plan de clivage de la facette 13, ou par combinaison des deux solutions. Dans ce mode de réalisation la première cavité 2 est donc délimitée par la première face extérieure 13' de la première section 5 et la face d'entrée 23 du guide d'onde 30 formant réflecteur 3.

La figure 2 représente un exemple d'espacements et d'imbrication des fréquences optiques des modes de fonctionnement de la première cavité 2, en traits pointillés, et des valeurs de fréquences optiques correspondant aux N pics de réflectivité (avec N = 9) du réflecteur 3, en traits pleins. Les fréquences optiques w sont portées en abscisse, les valeurs relatives des coefficients de réflectivité R des pics de réflectivité sont portées en ordonnée. Selon cet exemple, la différence entre deux fréquences optiques voisines quelconques de pics de réflectivité est constante.

En l'absence d'accord parfait entre les deux cavités, les valeurs des fréquences optiques des pics de réflectivité sont alternées avec des valeurs de fréquences optiques correspondant à des modes résonants de la première cavité 2, en sorte qu'une seule valeur de fréquence optique correspondant à un des modes résonants de la première cavité 2 est présente sur chaque intervalle entre deux valeurs consécutives de fréquence optique de pic de réflectivité du réflecteur 3. En d'autres termes, les fréquences optiques des pics de réflectivité sont entrelacées avec des fréquences optiques consécutives de modes résonants.

Par ailleurs, la cavité a été choisie pour présenter une différence entre deux fréquences optiques voisines de deux modes résonants telle que le rapport de cette différence à celle entre deux fréquences optiques voisines de pics de réflectivité soit égal à N/(N-1).

Ainsi, par changement de la valeur de tension de commande appliquée à la seconde section 6, on change l'indice optique de la seconde partie 8 de la couche active 4, et donc sa longueur optique. Il en résulte un glissement du peigne de résonance de la première cavité qui permet ainsi de passer d'un premier mode de fonctionnement dans lequel le laser 1 émet sur l'une des fréquences optiques correspondant à un premier pic de réflectivité du réflecteur 3 à un second mode de fonctionnement dans lequel le laser 1 émet sur une autre des fréquences optiques correspondant à un second pic de réflectivité du réflecteur 3.

Des indications seront données ci-après sur les ordres de grandeur à prendre en considération pour la réalisation de l'invention. Les explications seront données non seulement en référence à des fréquences optiques, mais aussi à des longueurs d'onde (dans le vide) correspondantes, plus habituelles dans le domaine des composants optiques.

Si L1 et n1 désignent respectivement la longueur et l'indice effectif de groupe de la première partie 7 de la couche active 4, et L2 et n2 la longueur et l'indice effectif de groupe de la seconde partie 8 de cette couche active, l'espacement ou pas des modes résonants de la première cavité 2 est donné par la formule :

$$\Delta\lambda = \lambda^2/2(n1L1 + n2L2) , \qquad (1)$$

dans laquelle $\Delta\lambda$ représente l'espacement entre deux valeurs consécutives de longueur d'onde de résonance de la cavité 2.

Pour des valeurs de n1 et n2 voisines de 3,2, et pour les longueurs d'onde comprises dans la grille ITU, pour 40 canaux avec un espacement de 100 GHz entre canaux consécutifs, cela conduit à une cavité 2 permettant au plus 39 modes résonants dans cette plage de fréquences optiques. La longueur de la cavité L1 + L2 est alors voisine de 460 $\mu$m. Avec un espacement de 50 GHz, cette longueur serait d'environ 920 $\mu$m.

Pour couvrir cette plage de fréquences optiques, la variation d'indice effectif de groupe $\Delta$n2 nécessaire est donné en fonction de la longueur d'onde $\lambda$ et de la longueur L2 de la seconde partie 8 de la couche active 4 par la formule :

$$\Delta n2 = \lambda/(2L2) \qquad (2)$$

La variation que l'on peut obtenir par un effet Franz-Keldish étant de $\Delta$n2 = $5.10^{-3}$, cela conduit à une longueur L2 pour la section de phase 6 de 150 $\mu$m. Pour couvrir 40 canaux avec un espacement de 100 GHz entre canaux consécutifs, ou de 50 GHz, la section 5 active doit alors avoir une longueur L1 d'environ 300 ou 770 $\mu$m respectivement.

De telles longueurs pour L1 et L2 sont compatibles avec une forte puissance d'émission et une largeur de bande étroite. Il est possible cependant d'améliorer la structure verticale des couches composant la seconde section pour avoir une variation d'indice plus forte, ce qui permet de réduire la longueur L2 et corrélativement d'augmenter la longueur L1. On peut alors obtenir une puissance d'émission plus forte. Pour obtenir un meilleur contrôle ou une sélectivité modale plus grande de la première cavité 2, on peut avoir intérêt à avoir un espacement plus grand entre les longueurs d'onde de résonance. Cela sera obtenu par une réduction de la longueur L1 + L2 de la cavité.

Le nombre de fréquences de résonance de la cavité 2 de Fabry-Pérot compris dans la zone d'utilisation de cette cavité 2 est déterminé par la longueur L1 + L2 de la cavité 2. La précision sur l'espacement entre canaux consécutifs dépend de la précision au niveau de l'étape de clivage des faces transversales de la cavité. Cette précision est en général de 5 $\mu$m en plus ou en moins par rapport à la longueur souhaitée. La variation d$\Delta\lambda$ de l'espacement entre longueurs d'onde consécutives de résonance en fonction de la variation d(L1 + L2) de la longueur totale de la cavité 2 peut s'exprimer par :

$$d\Delta\lambda = 2. \, d(L1 + L2) \, (\Delta\lambda/\lambda)^2 \qquad (3)$$

Ainsi pour un espacement de 50 GHz entre canaux consécutifs la précision de l'espacement des fréquences de résonance de la cavité 2 est inférieure à 1 GHz. Un écart aussi petit peut être aisément compensé par action sur la commande de la section 6 de contrôle de phase.

Cela montre que l'invention ne nécessite pas de prévoir de "Vé" dans le procédé de clivage. De façon en elle-même connue, le Vé est un procédé technologique permettant d'améliorer la précision de clivage de + ou - 5 μm à + ou - 1 μm.

Il convient également de remarquer que le contrôle des modes résonants de la seconde cavité 11 formée avec le guide d'onde 30 extérieur, dépend de la phase introduite dans l'onde de retour par le réflecteur 3. Les différences de phase introduites pour chaque pic de réflectivité sont identiques entre elles et égales par exemple à π/2.

Cela signifie que le mode lasant peut être contrôlé de façon identique pour chacun des canaux, par exemple en introduisant un retard de phase, par exemple sous forme d'un déphaseur contrôlé, au début du guide d'onde 30. Un tel déphaseur contrôlé est représenté de façon symbolique sur figure 1 par un carré 14. Comme signalé plus haut, la séparation entre la première cavité 2 du laser dans le premier mode de réalisation et l'entrée du guide ou de la fibre 30, peut être de l'ordre de plusieurs dizaines de microns. Il convient de tenir compte de cette distance dans le calcul de l'écart de phase de l'onde réfléchie par le réflecteur 3. Dans le second mode de réalisation dans lequel la cavité 2 est définie entre la face arrière 13' du laser à semi-conducteur 20 et l'entrée 23 du guide d'onde 30 on n'aura pas de déphasage supplémentaire à introduire dans les calculs.

Des exemples de modes particuliers de réalisation de guides d'onde 30, de formation de la seconde cavité 11 et de réseaux échantillonnés 40 seront maintenant commentés en liaison avec la figure 3. Sur cette figure les éléments déjà commentés en liaison avec la figure 1 ne seront pas décrits à nouveau. La figure 3 comporte trois parties A, B, et C.

Sur la partie A le réseau échantillonné 40 de réseaux réflecteurs 31, 33 ... de Bragg distribués (SG DBR) est réalisé sur un guide d'onde 30 constitué par une fibre optique. Le coefficient de réflexion R1 de la face clivée 13 de la couche active 4 faisant face à la fibre optique 30 doit être adapté pour les faibles courants de seuils, les fortes puissances et un fonctionnement monomode.

Sur la partie B de la figure 3, le guide d'onde 30 est un guide d'onde en polymère ou en silice. Il est possible dans ce cas de monter le laser semi conducteur 20 et le guide 30 sur un substrat commun 15, par exemple en silicium, en utilisant une technique d'auto-alignement entre la fibre et le laser semi conducteur.

Sur la partie C de la figure 3, le guide d'onde 30 est un guide d'onde en InP qui peut être réalisé sur un substrat 9' commun au laser semi conducteur 20 et au guide 30.

La séparation de la cavité 2 et du guide 30 peut être réalisée dans les cas B et C par une gravure 16 formant le miroir de la face 13 située en regard de l'entrée du guide 30.

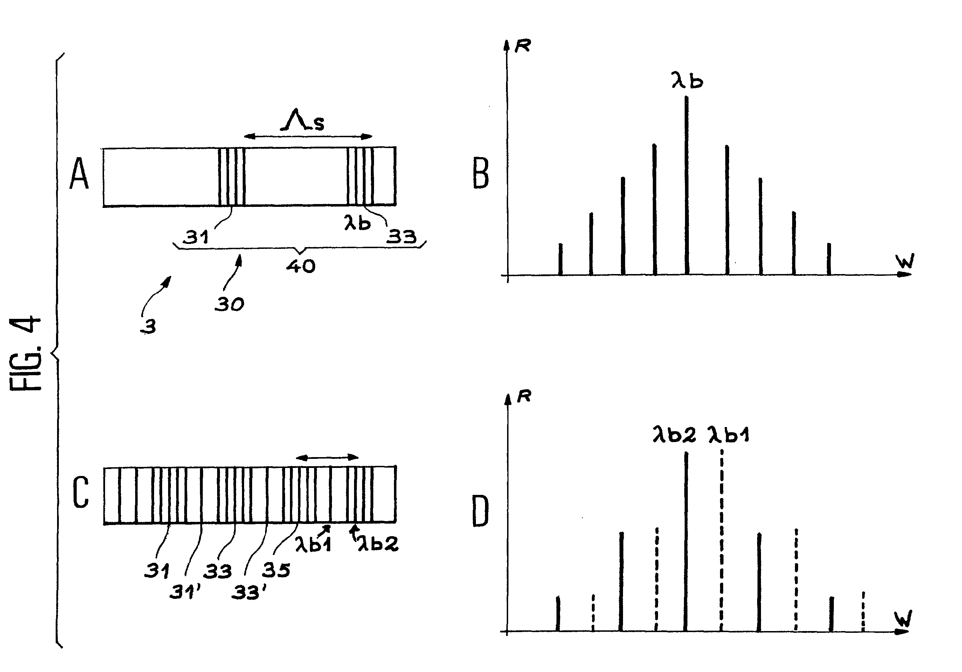

Des indications sur des modes de réalisation du réseau réflecteur échantillonné 40 seront maintenant données en liaison avec la figure 4.

Comme déjà indiqué plus haut, le réseau réflecteur échantillonné 40 ("Sample Grating") est constitué par une alternance d'échantillons de réseaux réflecteurs de Bragg distribués, ("Distributed Bragg Reflector", DBR) 31, 33... et de sections 32, 34... de Fabry-Pérot, constituées chacune par une partie de guide d'onde sans échantillons de réseau de Bragg.

La longueur Λs d'une période d'échantillonnage formée de l'addition de la longueur d'un échantillon de réseau réflecteur de Bragg et de la longueur d'une cavité de Fabry-Pérot dépend de l'espacement souhaité pour les fréquences correspondant à des pics de réflectivité. Pour un guide d'onde par exemple en silice ou en polymère ayant un indice n de 1,5 cette période sera de 1 mm ou 2 mm pour des espacements de 100 ou 50 GHz respectivement. La relation entre l'espacement des longueurs d'onde des pics de réflectivité $\Delta\lambda$pic, la longueur d'onde du pic λ, l'indice n du guide et la longueur Λs de la période d'échantillonnage est donnée par la formule

$$\Delta\lambda\text{pic} = \lambda^2/(2n.\Lambda s) \qquad (4)$$

Le nombre de périodes d'échantillonnage dépend de la valeur de réflectivité souhaitée. Il est de 10 à 15 en fonction des coefficients de couplage des réseaux de Bragg 31, 33 (valeur de Kappa) que l'on peut obtenir et de la valeur du coefficient de réflexion à atteindre. Cela conduit à des longueurs de réseau échantillonné de plusieurs mm. Pour un nombre de périodes compris entre 10 et 15, une valeur de n proche de 1,5 et $\Delta\lambda$pic égal à 1 nanomètre (correspondant à un espacement en fréquence de l'ordre de 100 GHz), Λs est voisin de 800 μm. Ainsi, pour un réseau composé de 10 à 15 périodes, la longueur totale est de l'ordre de 8 à 12 mm. Pour un espacement en fréquence de l'ordre de 50 GHz, cette longueur totale est doublée, soit 16 à 24 mm.

De façon avantageuse le réseau peut avoir un pas qui n'est pas constant sur la période d'échantillonnage (réseau chirpé). Ce type de réseau "chirpé" peut être très utile pour la stabilisation modale du laser comme indiqué dans le document de référence [3] cité en fin de la description.

Pour des facilités de fabrication il est préférable de réaliser le réseau échantillonné sur une fibre comme représenté figure 3 partie A ou sur un guide d'onde en silice ou en polymère comme représenté figure 3 partie B. Dans le cas de la fibre ou du guide d'onde en silice ou en polymère, les échantillons de réseaux de Bragg 31, 33 peuvent être réalisés par insolation directe. En particulier dans le cas des fibres ou guides en silice, en plus des avantages bien connus de ces guides (faibles pertes, technologies bien maîtrisées, fiabilité), il est à noter que l'indice optique de ces guides peut être ajusté de façon continue par une procédure d'illumination uniforme du guide. Cet ajustement de la valeur de l'indice n permet un réglage fin de l'espacement des longueurs d'onde des pics de réflectivité $\Delta\lambda$pic.

Le réseau échantillonné peut aussi être intégré sur guide d'onde en InP comme représenté figure 3 partie C. On note cependant que les longueurs nécessaires (plusieurs mm) pour réaliser ces réseaux peuvent conduire à de réelles difficultés de réalisation pratique. Afin de réduire cette longueur, on peut employer une méthode qui sera décrite ci-après en liaison avec la figure 4.

Il a été vu plus haut (relation 4) que la période $\Lambda$s du réseau échantillonné 40 constitué par une alternance d'échantillons de réseaux réflecteurs distribués 31, 33 de Bragg et de cavités de Fabry-Pérot est inversement proportionnelle à l'espacement des longueurs d'onde correspondant à la période des pics de réflectivité. On a représenté en figure 4 partie A un guide d'onde pour lequel par exemple le réseau échantillonné 40 a une période $\Lambda$s correspondant à un espacement de 100 GHz pour les pics de réflectivité. Cet espacement est relatif à une longueur d'onde du réseau $\lambda$b comme représenté en figure 4 partie B.

Dans le mode de réalisation représenté figure 4 parties C et D, des échantillons 31, 33 d'un premier réseau échantillonné à réflecteur distribué de Bragg correspondant à une première longueur d'onde de Bragg $\lambda_{B1}$ sont alternées, à l'exception éventuellement d'un premier ou d'un dernier, avec des échantillons 31' 33' d'un second réseau échantillonné à réflecteur distribué de Bragg correspondant à une seconde longueur d'onde de Bragg $\lambda_{B2}$ différente de $\lambda_{B1}$. Dans le mode de réalisation représenté figure 4 partie C, les échantillons du second réseau se trouvent au centre des espaces entre deux échantillons du premier réseau réflecteur distribué de Bragg. On obtient ainsi avec une même longueur de guide d'onde un espacement deux fois plus petit entre valeurs consécutives de longueur d'onde correspondant à des pics de réflectivité du guide d'onde échantillonné. Ainsi par exemple avec des longueurs d'onde centrales $\lambda$b1 et $\lambda$b2 espacées entre elles de 50 GHz, on peut obtenir des pics de réflectivité espacés entre eux de 50 GHz alors que chacun des deux réseaux correspond à un espacement entre pics consécutifs de 100 GHz.

Le même principe peut être répété plusieurs fois et ainsi la longueur du réflecteur échantillonné 40 peut être divisé par deux plusieurs fois.

Par exemple pour un système avec un espacement de 100 GHz entre les fréquences consécutives des pics de réflectivité, tracé dans un guide d'onde InP ayant un indice optique de 3,2, si quatre réseaux sont tracés, la période d'échantillonnage est d'environ 120 $\mu$m. Cela conduit à un réflecteur échantillonné de 1,2 mm pour un réseau de 10 périodes, ce qui devient réalisable sur un guide d'onde en InP. L'un des avantages de ce mode de réalisation du réseau échantillonné 40 est que l'on peut réaliser des réseaux réflecteurs distribués de Bragg ayant des coefficients de couplage supérieur à 100 ou même 200 cm$^{-1}$ puisque l'on peut alors augmenter le nombre de périodes.

Dans le mode de réalisation de réseaux échantillonnés qui vient d'être décrit, on a utilisé la relation 4 en conservant pour $\Lambda$s une valeur constante et en faisant varier la longueur d'onde de chacun des réseaux échantillonnés de façon à avoir plusieurs réseaux échantillonnés imbriqués les uns dans les autres. L'intérêt de cette formule est que $\Lambda$s étant constant, quel que soit le nombre de périodes du réseau échantillonné, les réseaux successifs de Bragg seront bien distincts les uns des autres et toujours à la même distance les uns des autres. Si le nombre de périodes du réseau échantillonné est faible, on peut non seulement jouer sur la longueur d'onde $\lambda$ de chacun des réseaux imbriqués, mais aussi sur la périodicité $\Lambda$s de façon à avoir plusieurs réseaux échantillonnés imbriqués les uns dans les autres. Cette imbrication, avec une valeur différente pour $\Lambda$s, pourra être réalisée pour autant que les tracés des réseaux ne soient pas superposés en certains points.

Comme déjà expliqué en liaison avec la figure 3 partie C, la face réfléchissante 13 de la cavité 2 de Fabry-Perot peut être gravée directement dans le semi conducteur.

Dans un laser selon l'invention la simplicité de la commande d'accord et de l'électronique qui lui est associée provient du fait que l'accord est obtenu par action sur une seule grandeur de commande, la tension de commande appliquée à la seconde section 6. La rapidité de réalisation des accords est dû à l'emploi conjugué d'un effet électro-optique intrinsèquement très rapide et à la simplicité de l'électronique de commande. Dans les lasers accordable comme celui décrit en [2] dans lequel le changement de la fréquence d'accord est obtenu par injection de porteurs, il est nécessaire d'agir sur au moins deux courants de façon synchronisée.

Les documents cités [1], [2], [3] et [4] en référence sont :

[1] F. Delorme et Al, IEE Photonics Technology Letters, Vol. 17, N° 3, P.269, Mars 1995.
[2] J. F. Lemieux, M. Tetu, Electronic Letters, Vol 35, n° 11, P. 904, Mai 1999.
[3] : P.A. Morton et al, "Stable and single mode hybrid laser with high power and narrow linewidth", Applied Physics Letters, Vol 64, n° 20; 16 May 94.
[4] : Morten Ibsen et al, "Sinc-Sampled Fiber Bragg Gratings for Identical Multiple Wavelength Operation", IEEE Photonics Technology Letters, Vol. 10, n° 6, Juin 1998, p. 842-844.

## Revendications

1. Laser (1) accordable en longueur d'onde, comprenant une première cavité résonante (2) contenant un milieu amplificateur optique (7), et un réflecteur (3) extérieur à ladite première cavité (2) délimitant une seconde cavité (11), ledit réflecteur (3) présentant des pics de réflectivité pour un nombre entier N de fréquences optiques, **caractérisé en ce que** la première cavité (2) est formée de deux éléments réflecteurs opposés (13', 13, 23) non sélectifs en longueur d'onde et délimitant une première section active (5) amplificatrice couplée à une seconde section active (6) d'accord de phase, chacune des deux sections (5, 6) étant raccordable à une source électrique qui lui est propre, ladite seconde section active (6) présentant un indice effectif de groupe réglable par effet électro-optique en fonction d'une tension électrique appliquée à ladite seconde section active (6), lesdites première et seconde sections actives (5, 6) étant dimensionnées de sorte que la différence entre les fréquences optiques de deux modes résonants quelconques de ladite première cavité (2) ne soit jamais égale à la différence entre les fréquences optiques de deux pics de réflectivité quelconques dudit réflecteur (3).

2. Laser (1) accordable en longueur d'onde selon la revendications 1, **caractérisé en ce que** la différence entre deux fréquences optiques voisines quelconques de pics de réflectivité étant constante, les fréquences optiques desdits pics de réflectivité sont entrelacées avec des fréquences optiques consécutives de modes résonants.

3. Laser (1) accordable en longueur d'onde selon la revendication 2, **caractérisé en ce que** le rapport de la différence entre deux fréquences optiques voisines de deux modes résonants à la différence entre deux fréquences optiques voisines de pics de réflectivité est égal à $N/(N-1)$.

4. Laser (1) accordable en longueur d'onde selon l'une des revendications 1 à 3, **caractérisé en ce que** le réflecteur (3) extérieur est un guide d'onde (30) comportant au moins un réseau (40) réflecteur de Bragg échantillonné optiquement couplé à la première cavité (2).

5. Laser (1) accordable en longueur d'onde selon la revendication 4, **caractérisé en ce que** le guide d'onde (30) comporte plusieurs réseaux (40) réflecteurs de Bragg échantillonnés, chaque échantillon (31, 33) d'un premier réseau, à l'exception éventuellement d'un premier ou d'un dernier, se trouvant entre deux échantillons (31' 33') consécutifs d'un second réseau.

6. Laser (1) accordable en longueur d'onde selon l'une des revendications 4 ou 5, **caractérisé en ce qu'**un réseau échantillonné de Bragg du guide d'onde (30) a un pas qui n'est pas constant.

7. Laser (1) accordable en longueur d'onde selon l'une des revendications 1 à 6, **caractérisé en ce que** la première cavité (2) est formée entre une première face extérieure (13') de la première section (5) et une face extérieure (13) de la seconde section (6).

8. Laser (1) accordable en longueur d'onde selon l'une des revendications 1 à 6, **caractérisé en ce que** la première cavité (2) est formée entre une première face extérieure (13') de la première section (5) et une face d'entrée (23) dudit réflecteur (3).

9. Laser (1) accordable en longueur d'onde selon l'une des revendications 1 à 8, **caractérisé en ce que** la variation de l'indice effectif de groupe de la seconde section (6) d'accord de phase est obtenu par effet de Franz Keldysh.

10. Laser (1) accordable en longueur d'onde selon l'une des revendications 1 à 8, **caractérisé en ce que** la variation de l'indice effectif de groupe de la seconde section (6) d'accord de phase est obtenu par effet électrooptique de Stark de confinement quantique.

FIG. 1

FIG. 2

FIG. 3

FIG. 4

Office européen
des brevets

**RAPPORT DE RECHERCHE EUROPEENNE**

Numéro de la demande
EP 02 29 0422

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.7) |
|---|---|---|---|
| D,Y | LEMIEUX J-F ET AL: "Step-tunable (100 GHz) hybrid laser based on Vernier effect between Fabry-Perot cavity and sampled fibre Bragg grating" ELECTRONICS LETTERS, IEE STEVENAGE, GB, vol. 35, no. 11, 27 mai 1999 (1999-05-27), pages 904-906, XP006012176 ISSN: 0013-5194 * page 904, colonne de droite, ligne 6-11; figures 1,2 * | 1-10 | H01S5/14 H01S5/0625 |
| Y | WO 00 22705 A (ACREO AB ;RIGOLE PIERRE JEAN (SE)) 20 avril 2000 (2000-04-20) * page 3, ligne 4-12; figure 7 * * page 6, ligne 10 - page 8, ligne 32 * | 1-10 | |
| A | EP 0 300 790 A (KOKUSAI DENSHIN DENWA CO LTD) 25 janvier 1989 (1989-01-25) * figure 2 * | 1 | |
| A | US 6 088 373 A (HAKKI BASIL WAHID) 11 juillet 2000 (2000-07-11) * le document en entier * | 1 | **DOMAINES TECHNIQUES RECHERCHES (Int.Cl.7)** H01S |
| A | MORTON P A ET AL: "STABLE SINGLE MODE HYBRID LASER WITH HIGH POWER AND NARROW LINEWIDTH" APPLIED PHYSICS LETTERS, AMERICAN INSTITUTE OF PHYSICS. NEW YORK, US, vol. 64, no. 20, 16 mai 1994 (1994-05-16), pages 2634-2636, XP000449693 ISSN: 0003-6951 * figure 1 * | 1-10 | |

Le présent rapport a été établi pour toutes les revendications

| Lieu de la recherche | Date d'achèvement de la recherche | Examinateur |
|---|---|---|
| LA HAYE | 24 juin 2002 | Claessen, L |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)

**EP 1 235 318 A1**

**ANNEXE AU RAPPORT DE RECHERCHE EUROPEENNE**
**RELATIF A LA DEMANDE DE BREVET EUROPEEN NO.**            EP 02 29 0422

La présente annexe indique les membres de la famille de brevets relatifs aux documents brevets cités dans le rapport de recherche européenne visé ci–dessus.
Lesdits members sont contenus au fichier informatique de l'Office européen des brevets à la date du
Les renseignements fournis sont donnés à titre indicatif et n'engagent pas la responsabilité de l'Office européen des brevets.

24-06-2002

| Document brevet cité au rapport de recherche | | Date de publication | Membre(s) de la famille de brevet(s) | | Date de publication |
|---|---|---|---|---|---|
| WO 0022705 | A | 20-04-2000 | AU | 1194200 A | 01-05-2000 |
| | | | CN | 1324505 T | 28-11-2001 |
| | | | EP | 1118145 A1 | 25-07-2001 |
| | | | SE | 9803285 A | 29-03-2000 |
| | | | WO | 0022705 A1 | 20-04-2000 |
| EP 0300790 | A | 25-01-1989 | JP | 1024483 A | 26-01-1989 |
| | | | JP | 8031653 B | 27-03-1996 |
| | | | DE | 3884503 D1 | 04-11-1993 |
| | | | DE | 3884503 T2 | 10-02-1994 |
| | | | EP | 0300790 A2 | 25-01-1989 |
| | | | KR | 9707117 B1 | 02-05-1997 |
| | | | US | 4852108 A | 25-07-1989 |
| US 6088373 | A | 11-07-2000 | AUCUN | | |

EPO FORM P0460